# EUROPÄISCHE PATENTANMELDUNG

(11) **EP 1 843 471 A2**
(43) Veröffentlichungstag der Anmeldung: **10.10.2007**
(21) Anmeldenummer: 07006193.2
(22) Anmeldetag: 26.03.2007
(51) Int. Cl.: H03K 19/003, H03K 19/0185

(54) **Schaltungsanordnung zur Glitch-freien oder Glitch-reduzierten Signalübertragung zwischen Spannungsbereichen**

(30) Priorität: 05.04.2006 DE 102006016356
(71) Anmelder: Micronas GmbH, 79108 Freiburg (DE)
(72) Erfinder: Ehlert, Martin, 79114 Freiburg (DE)
(74) Vertreter: Patentanwälte Westphal, Mussgnug & Partner

(57) **Zusammenfassung**

Die Erfindung bezieht sich auf eine Schaltungsanordnung zur Glitch-freien oder Glitch-reduzierten Signalübertragung zwischen Spannungsbereichen mit
- einem Open-drain-Schaltung (1) in einem ersten Spannungsbereich (V1) und einer Last (2) in einem zweiten Spannungsbereich (V2),
- wobei die Open-drain-Schaltung (1) ausgebildet ist, abhängig von einem Zustand eines Eingangssignals (in) an einem ersten Knoten (a) und einem zweiten Knoten (b), welche der Last (2) angelegt sind, ein Signal anzulegen und
- wobei abhängig von dem Zustand des ersten Knoten (a) ein Ausgangssignal (out) ausgegeben wird,
- wobei eine Auswertelogik (3) der Last (2) nachgeschaltet ist, wobei die Auswertelogik (3) zum Bereitstellen des Ausgangssignals (out) zum Auswerten des Zustands des ersten Knoten (a) und des Zustands des zweiten Knoten (b) ausgebildet ist.

## Beschreibung

Die Erfindung bezieht sich auf Schaltungsanordnung zur Glitch-freien oder Glitch-reduzierten Signalübertragung zwischen Spannungsbereichen mit den oberbegrifflichen Merkmalen gemäß Patentanspruch 1.

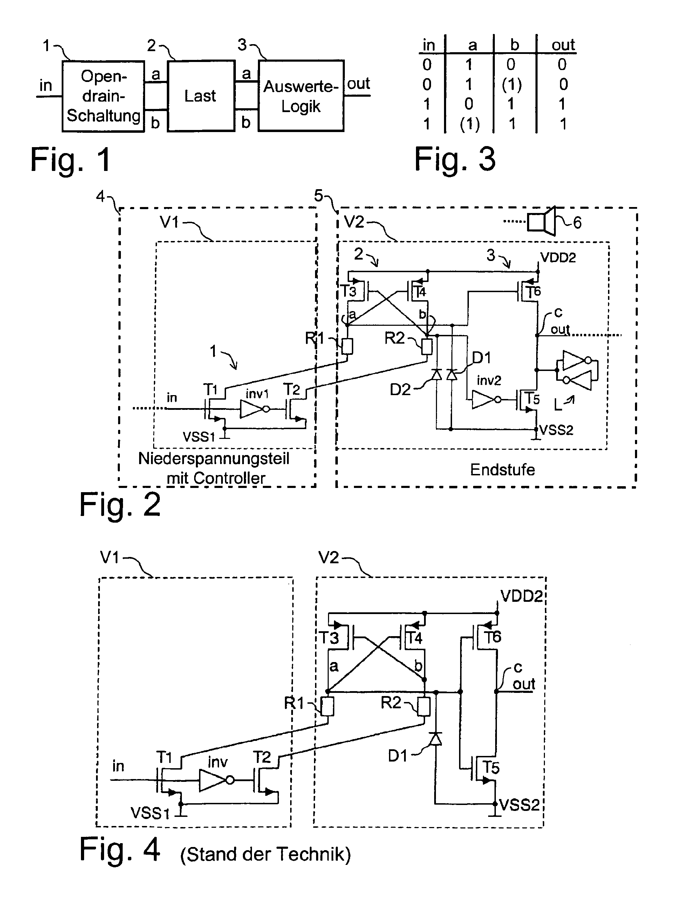

In impulsweiten-modulierten Verstärkern, wie sie bei Audioverstärkern verwendet werden, werden Schaltungsanordnungen eingesetzt, welche als ESD-geschützte (ESD: Electro Static Discharge / elektrostatische Entladung) Pegelanpassschaltung einen ersten Pegel eines ersten Spannungsbereichs V1 in einen zweiten Pegel eines zweiten Spannungsbereichs V2 umsetzen. Eine beispielhafte Schaltungsanordnung gemäß dem Stand der Technik ist anhand Fig. 4 skizziert. Von einer solchen Schaltungsanordnung sind die im ersten Spannungsbereich V1, welcher auch als "voltage domain" bezeichnet wird, enthaltenen Schaltungskomponenten üblicherweise im Niederspannungsteil eines derartigen Verstärkers angeordnet, wobei der Niederspannungsteil die Logik, beispielsweise einen Controller, enthält. Die Schaltungskomponenten des zweiten Spannungsbereichs V2 bilden den Eingang z.B. einer Audioendstufe. Ziel einer solchen Schaltungsanordnung ist, dass ein Eingangssignal in, welches aus dem ersten Spannungsbereich V1 bereitgestellt wird, hinsichtlich seiner Logik dem Ausgangssignal out für den zweiten Spannungsbereich V2 entspricht. Zum ESD-Schutz dienen zwei zwischen die beiden Spannungsbereiche V1, V2 geschaltete Widerstände und eine ESD-Diode.

Das Eingangssignal in wird im ersten Spannungsbereich V1 an der Basis eines ersten Transistors T1 angelegt, welcher zwischen einen ersten Widerstand R1 und eine erste Grundspannung VSS1 des ersten Spannungsbereichs V1 geschaltet ist. Außerdem wird das Eingangssignal in einem Inverter inv1 invertiert und einem dem Inverter inv1 nachgeschalteten zweiten Transistor T2 an dessen Basis angelegt. Der zweite Transistor T2 ist zwischen einen zweiten Widerstand R2 und die erste Grundspannung VSS1 geschaltet. Die beiden Widerstände R1, R2 sind vorzugsweise bereits auf dem Schaltungsteil des zweiten Spannungsbereichs V2 angeordnet. Der erste Widerstand R1 ist über einen ersten Knoten a und die Emitter-Kollektor-Strecke eines dritten Transistors T3 an eine Versorgungsspannung VDD2 des zweiten Spannungsbereichs V2 schaltbar. Außerdem ist der erste Knoten a an die Basis eines vierten Transistors T4 geschaltet, welcher zwischen die Versorgungsspannung VDD2 und einen zweiten Knoten b geschaltet ist. Der zweite Knoten b ist mit der Basis des dritten Transistors T3 verbunden, um diesen anzusteuern. Außerdem ist der zweite Widerstand R2 zwischen den zweiten Transistor T2 und den zweiten Knoten b geschaltet. Das Ausgangssignal könnte bereits direkt an dem ersten Knoten a abgegriffen werden.

Zur Bereitstellung des Ausgangssignals out sind jedoch vorzugsweise ein fünfter und ein sechster Transistor T5, T6 zwischen eine zweite Grundspannung VSS2 und die Versorgungsspannung VDD2 des zweiten Spannungsbereichs V2 in Art eines Inverters geschaltet. Die beiden Basisanschlüsse des fünften und des sechsten Transistors T5, T6 sind an den ersten Knoten a geschaltet. Das Ausgangssignal out wird an einem Ausgangsknoten c zwischen den beiden Emitter-Kollektor-Strecken des fünften und des sechsten Transistors T5, T6 abgegriffen. Eine erste Diode D1 dient als die ESD-Diode und ist zwischen die zweite Grundspannung VSS2 und den ersten Knoten a geschaltet.

Mit einer solchen Schaltungsanordnung können ESD-sichere Signalübertragungen zwischen Spannungsbereichen durch eine Pegelverschiebung von Signalen aus dem ersten Spannungsbereich V1 in den zweiten Spannungsbereich V2 durchgeführt werden. Durch eine solche Schaltung werden ESD-Impulse nicht zwischen den verschiedenen Spannungsbereichen V1, V2 übertragen. Im Fall eines normalen Betriebs liegen an den beiden Knoten a, b, üblicherweise immer zueinander inverse Signale an. Im Falle eines hohen Spannungspegels des Eingangssignals in zieht der erste Transistor T1 den ersten Knoten a auf die erste Grundspannung VSS1. Dies bewirkt, dass der vierte Transistor T4 den zweiten Knoten b auf die Versorgungsspannung VDD2 zieht. Der zweite und der dritte Transistor T2, T3 sind ausgeschaltet. Entsprechend liegt der erste Knoten a, welcher auf die erste Grundspannung VSS1 gezogen ist, an dem Inverter an, welcher durch den fünften und den sechsten Transistor T5, T6 gebildet wird. Dadurch wird das invertierte Signal des ersten Knotens a als das in den zweiten Spannungsbereich V2 geschobene Ausgangssignal out angelegt. Der durch den fünften und den sechsten Transistor T5, T6 gebildete Inverter isoliert den ersten Knoten a von einer Last, welche am Ausgangsknoten c das Ausgangssignal out bereitstellt.

Bei einer solchen Schaltungsanordnung wird eine mit dem Ausgangssignal out versorgte Last somit auf einen Spannungspegel zwischen der Versorgungsspannung VDD2 und der zweiten Grundspannung VSS2 des zweiten Spannungsbereichs V2 in Abhängigkeit von dem Spannungspegel des ersten Knoten a geschaltet.

Insbesondere in Verstärkerschaltungen besteht das Problem, dass sogenannte Glitches auftreten, d. h. kurzzeitige Störungen, welche zu unerwünschten Spannungsspitzen oder Impulsverzerrung führen und zu Stromimpulsen im Bereich von beispielsweise 6 - 7 Ampere führen können. Derartige Störungen bewirken ein nicht kontinuierlich stabil gehaltenes Ausgangssignal out und können insbesondere in Umgebungen mit einem hohen Substratrauschen zwischen den beiden Spannungsbereichen V1, V2, insbesondere zwischen den beiden Grundspannungen VSS1, VSS2, entstehen, wenn ein hochpegeliges Eingangssignal in zu übertragen ist. Im Fall des hochpegeligen Eingangssignals in wird der erste Knoten a auf die erste Grundspannung VSS1 geschaltet. Falls die erste Grundspannung VSS1 auf Grund von Rauschen größer wird als die zweite Grundspannung VSS2, führt dies dazu, dass der fünfte Transistor T5 eingeschaltet wird. Abhängig von dem Verhältnis zwischen dem fünften und dem sechsten Transistor T5, T6 kann der Ausgangsknoten c schließlich vom niedrigpegeligen in den hochpegeligen Zustand ändern, wenn das Verhältnis, insbesondere die Differenz der zweiten von der ersten Grundspannung VSS1 - VSS2 den Schaltpegel des durch den fünften und den sechsten Transistor T5/T6 gebildeten Inverters erreicht, während der Pegel der Eingangslogik noch niedrigpegelig ist. In einem solchen Fall führt dies dazu, dass das Ausgangssignal out im Vergleich zum Eingangssignal in wackelt, d. h. keinen definierten gültigen Endzustand einnimmt, wenn beispielsweise das Potential der ersten Grundspannung VSS1 zum Potential der zweiten Grundspannung VSS2 aus irgendwelchen Gründen ansteigt. Derartige starke Störungen können bewirken, dass die beiden Potentiale der Grundspannungen VSS1, VSS2 zueinander so stark wegdriften, dass die Kippspannung des hinteren Inverters mit dem fünften und dem sechsen Transistor T5, T6 überschritten wird, also insbesondere ungefähr der Hälfte der Versorgungsspannung VDD2/2 beträgt.

Die Aufgabe der Erfindung besteht darin, eine Schaltungsanordnung zur Glitch-freien oder Glitch-reduzierten Signalübertragung zwischen Spannungsbereichen vorzuschlagen.

Diese Aufgabe wird gelöst durch eine Schaltungsanordnung zur Glitch-freien oder Glitch-reduzierten Signalübertragung zwischen Spannungsbereichen mit den Merkmalen gemäß Patentanspruch 1 sowie durch einen impulsweiten-modulierten Verstärker mit einer solchen Schaltungsanordnung. Vorteilhafte Ausgestaltungen sind Gegenstand von abhängigen Ansprüchen.

Bevorzugt wird demgemäß eine Schaltungsanordnung zur Glitch-freien oder Glitch-reduzierten Signalübertragung zwischen Spannungsbereichen mit einer Open-drain-Schaltung, insbesondere einem Open-drain-Inverter in einem ersten Spannungsbereich und einer Last in einem zweiten Spannungsbereich, wobei die Open-drain-Schaltung ausgebildet ist, abhängig von einem Zustand eines Eingangssignals an einem ersten Knoten und einem zweiten Knoten, welche der Last angelegt sind, ein Signal anzulegen und wobei abhängig von dem Zustand des ersten Knoten ein Ausgangssignal ausgegeben wird, wobei eine Auswertelogik der Last nachgeschaltet ist, wobei die Auswertelogik zum Bereitstellen des Ausgangssignals zum Auswerten des Zustands des ersten Knoten und des Zustands des zweiten Knoten ausgebildet ist.

Bevorzugt wird insbesondere eine Schaltungsanordnung, bei welcher die Open-drain-Schaltung das Eingangssignal an einem ersten Transistor und über einen ersten Inverter an einem zweiten Transistor anlegt, wobei der erste Transistor schaltbar ist, den ersten Knoten auf eine erste Grundspannung des ersten Spannungsbereichs zu schalten, und wobei der zweite Transistor ausgelegt ist, den zweiten Knoten auf die erste Grundspannung zu schalten.

Bevorzugt wird insbesondere eine Schaltungsanordnung, bei welcher die Last einen dritten Transistor und einen vierten Transistor aufweist, wobei der dritte Transistor geschaltet ist, abhängig vom Zustand des zweiten Knotens den ersten Knoten auf eine Versorgungsspannung des zweiten Spannungsbereichs zu schalten, und wobei der vierte Transistor geschaltet ist, den zweiten Knoten abhängig vom Zustand des ersten Knotens auf die Versorgungsspannung zu schalten.

Bevorzugt wird insbesondere eine Schaltungsanordnung, bei welcher die Auswertelogik einen fünften Transistor aufweist, der über einen zweiten Inverter mittels des zweiten Knotens geschaltet wird, und einen sechsten Transistor aufweist, welcher über den Zustand des ersten Knotens geschaltet wird, wobei ein Ausgangsknoten zum Bereitstellen des Ausgangssignals zwischen den fünften und den sechsten Transistor geschaltet ist, und wobei der fünfte Transistor über den zweiten Inverter mittels des zweiten Knotens zum Schalten des Ausgangsknoten auf eine zweite Grundspannung des zweiten Spannungsbereichs schaltbar ausgebildet ist und wobei der sechste Transistor den Ausgangsknoten auf eine Versorgungsspannung des zweiten Spannungsbereichs schaltbar ausgebildet ist.

Bevorzugt wird insbesondere eine Schaltungsanordnung, bei welcher an dem Ausgangsknoten ein Latch zum statischen Halten des letzten Ausgangszustands angelegt ist. Dies ermöglicht für den Fall, eines fehlerhaften hochpegeligen Zustands des ersten oder des zweiten Knotens und dadurch sowohl abgeschaltetem fünften als auch abgeschaltetem sechsten Transistor den Ausgangsknoten auf seinem letzten Zustandswert zu halten.

Bevorzugt wird insbesondere eine Schaltungsanordnung mit einem zwischen den ersten Transistor und den ersten Knoten geschalteten ersten Widerstand, einem zwischen den zweiten Transistor und den zweiten Knoten geschalteten zweiten Widerstand, einer zwischen eine zweite Grundspannung des zweiten Spannungsbereichs und den ersten Knoten geschalteten ersten Diode und einer zwischen die zweite Grundspannung und den zweiten Knoten geschalteten zweiten Diode als ESD-Schutzschaltung.

Ein Ausführungsbeispiel der Erfindung wird nachfolgend anhand der Zeichnung näher erläutert. Es zeigen:
- Fig. 1: eine schematische Prinzipskizze eines Grundaufbaus einer Schaltungsanordnung zum Glitch-freien Signalübertragen zwischen zwei eigenständigen Spannungsbereichen,
- Fig. 2: eine detaillierte Schaltungsanordnung einer solchen Schaltungsanordnung,
- Fig. 3: eine Tabelle mit Schaltzuständen verschiedener Signal innerhalb einer solchen Schaltungsanordnung und
- Fig. 4: eine Schaltungsanordnung gemäß dem Stand der Technik.

Fig. 1 zeigt schematisch das Grundprinzip einer bevorzugten Schaltungsanordnung zur Glitch-freien Signalübertragung zwischen Spannungsbereichen mit relativ zueinander eigenständiger Spannungsversorgung. Ein Eingangssignal in wird einer Open-drain-Schaltung 1, insbesondere einem Open-drain-Inverter angelegt, welcher sich in einem ersten Spannungsbereich befindet. Abhängig von dem Eingangssignal in stellt die Open-drain-Schaltung 1 Ausgangssignale an einem ersten bzw. an einem zweiten Knoten a, b, bereit, welche bei einem störungsfreien Betrieb einen zueinander inversen Zustand bzw. Pegel einnehmen. Die entsprechenden Signale bzw. Pegel an dem ersten und dem zweiten Knoten a, b werden einer Last 2 angelegt, welche vorzugsweise einen hohen Lastwiderstand aufweist.

Außerdem werden die Signale an den beiden Knoten a, b einer der Last 2 nachgeschalteten Auswertelogik 3 angelegt, welche insbesondere aus einem Inverter und Transistoren ausgebildet ist. Die Auswertelogik 3 gibt ein Ausgangssignal out abhängig von dem Zustand der beiden Signale an den beiden angelegten Knoten a, b aus. Das Ausgangssignal out nimmt hinsichtlich des Zustands des Eingangssignals, d. h. insbesondere hochpegelig oder niedrigpegelig, einen entsprechenden Zustand an. Bei der Auswertelogik 3 handelt es sich um eine pseudodifferenzielle Auswertung bzw. eine pseudodifferenzielle Auswertungsschaltung.

Für den Falle einer auftretenden Störung, beispielsweise den Falle einer sehr hohen Grundspannung in dem ersten Spannungsbereich des Eingangssignals in, kann das Signal an den beiden Knoten a, b gleich sein. Dadurch, dass die Auswertelogik 3 nicht nur das Signal eines der Knoten a sondern die Signale an beiden Knoten a und b berücksichtigt, kann trotzdem ein korrektes Ausgangssignal out durch eine entsprechende pseudodifferenzielle Auswertung bereitgestellt werden.

Eine beispielhafte und besonders bevorzugte Schaltungsanordnung ist anhand Fig. 2 veranschaulicht. Das Eingangssignal in wird im ersten Spannungsbereich V1 an der Basis eines ersten Transistors T1 angelegt, welcher zwischen einen ersten Widerstand R1 und eine erste Grundspannung VSS1 des ersten Spannungsbereichs V1 geschaltet ist. Außerdem wird das Eingangssignal in einem Inverter inv1 invertiert und einem dem Inverter inv1 nachgeschalteten zweiten Transistor T2 an dessen Basis angelegt. Der zweite Transistor T2 ist zwischen einen zweiten Widerstand R2 und die erste Grundspannung VSS1 geschaltet. Die beiden Widerstände R1, R2 sind vorzugsweise bereits auf dem Schaltungsteil des zweiten Spannungsbereichs V2 angeordnet. Der erste Widerstand R1 ist über einen ersten Knoten a und die Emitter-Kollektor-Strecke eines dritten Transistors T3 an eine Versorgungsspannung VDD2 des zweiten Spannungsbereichs V2 schaltbar. Außerdem ist der erste Knoten a an die Basis eines vierten Transistors T4 geschaltet, welcher zwischen die Versorgungsspannung VDD2 und einen zweiten Knoten b geschaltet ist. Der zweite Knoten b ist mit der Basis des dritten Transistors T3 verbunden, um diesen anzusteuern. Außerdem ist der zweite Widerstand R2 zwischen den zweiten Transistor T2 und den zweiten Knoten b geschaltet.

Zur Bereitstellung des Ausgangssignals out sind ein fünfter und ein sechster Transistor T5, T6 zwischen eine zweite Grundspannung VSS2 und die Versorgungsspannung VDD2 des zweiten Spannungsbereichs V2 geschaltet. Der Basisanschluss des sechsten Transistors T6 ist an den ersten Knoten a geschaltet. Der zweite Knoten b liegt über einen zwischengeschalteten zweiten Inverter inv2 an der Basis des fünften Transistors T5 an.

Das Ausgangssignal out wird an einem Ausgangsknoten c zwischen den beiden Emitter-Kollektor-Strecken des fünften und des sechsten Transistors T5, T6 abgegriffen.

Eine erste und eine zweite Diode D1, D2 sind als ESD-Dioden zwischen die zweite Grundspannung VSS2 und den ersten bzw. den zweiten Knoten a, b geschaltet. Sofern ein ESD-Schutz nicht gewünscht oder nicht erforderlich sein sollte, können diese Dioden D1, D2 und die beiden Widerstände R1 und R2 der beschriebenen Schaltungsanordnung gegebenenfalls auch entfallen.

Vorzugsweise ist an den Ausgangsknoten c zusätzlich ein Latch L in Form zweier in Reihe geschalteter Inverter oder optional eines Auffang-Flip-Flops geschaltet. Dies macht die Schaltungsanordnung robuster und unterstützt den Fall, dass sowohl der fünfte als auch der sechste Transistor T5, T6 beide abgeschaltet sind, was im Fehlerfall bei hochpegeligen Knoten a, b auftritt. Für den Fall, dass sowohl der fünfte als auch der sechste Transistor T5, T6 abgeschaltet sind, hält dieses Latch L den letzten Pegel des Ausgangsknotens c, so dass der letzte Ausgangszustand auch im Fall eines störenden Ereignisses statisch weiterhin als Ausgangssignal out bereitgestellt wird.

Bei dieser dargestellten Schaltungsanordnung gemäß Fig. 2 bilden die beiden ersten Transistoren T1, T2 und der zwischen diese geschaltete erste Inverter inv1 den Open-drain-Inverter aus. Der dritte und der vierte Transistor T3, T4, welche vorzugsweise als PMOS-Transistoren ausgebildet sind und einen hohen negativen Widerstand bieten, bildet die Last 2 aus. Der fünfte und der sechste Transistor T5, T6 und der dem fünften Transistor T5 vorgeschaltete zweite Inverter inv2 bilden die Auswertelogik 3 aus.

Besonders bevorzugt wird eine solche Schaltungsanordnung in einem Verstärker, insbesondere Audioverstärker eingesetzt, welcher ein Niederspannungsteil 4 mit einem Controller im ersten Spannungsbereich V1 aufweist, dessen Ausgangssignal als das Eingangssignal in für eine Endstufe 5 bereitgestellt wird. Die Endstufe 5 weist den zweiten Spannungsbereich V2 auf, wobei das Ausgangssignal out der beschriebenen Schaltungsanordnung als Eingangssignal für weitere Komponenten der Endstufe 5 bereitgestellt wird. Die Endstufe 5 dient im Fall eines Audioverstärkers insbesondere zur Verstärkung des Ausgangssignals out und zur Bereitstellung eines dem Ausgangssignal out entsprechend verstärkten Signals zur Audioausgabe über einen Lautsprecher 6.

Bei der anhand Fig. 2 beschriebenen Schaltungsanordnung werden somit beide Knoten a, b mit den verschobenen Pegeln für eine Signalübertragung verwendet. Sowohl der erste als auch der zweite Knoten a, b sind jeweils nur in einem Zustand und für nur einen Ausgangstyp ansprechbar. Falls der erste Knoten a auf die erste Grundspannung VSS1 gezogen wird und bei regulärem Betrieb der zweite Knoten b entsprechend auf die Versorgungsspannung VDD2 gezogen wird, dann wird der sechste Transistor T6 mittels des heruntergezogenen ersten Knoten a auf die Versorgungsspannung VDD2 gezogen. Falls hingegen der zweite Knoten b auf die erste Versorgungsspannung VSS 1 gezogen wird und bei regulärem Betrieb entsprechend der erste Knoten a auf die Versorgungsspannung VDD2 gezogen wird, wird hingegen der fünfte Transistor T5 vom zweiten Knoten b über den zweiten Inverter inv2 auf die zweite Grundspannung VSS2 gezogen.

Falls Substratrauschen oder ein sonstiger störender Zustand eintritt, kann störend der Fall eintreten, dass die beiden Knoten a und b in dem zweiten Spannungsbereich V2 fälschlich als hochpegelig an Stelle als niedrigpegelig interpretiert werden. Falls der erste Knoten a falsch interpretiert wird, wird bei dieser Schaltungsanordnung jedoch der zweite Knoten b trotzdem noch korrekt interpretiert und umgekehrt. Für den Fall von Rauschen oder einer sonstigen Störung werden der fünfte und der sechste Transistor T5, T6 abgeschaltet, so dass der Ausgangsknoten c isoliert wird. Der letzte logische Pegel wird an der parasitären Lastkapazität an diesem Knoten gespeichert. Dadurch wird die Schaltungsanordnung bereits ohne den Latch L Glitch-frei oder zumindest Glitch-reduziert.

Umsetzbar ist eine Vielzahl von alternativen Ausgestaltungen. Bevorzugt eingesetzt werden als Lasten kreuzgekoppelte PMOS-Transistoren, wie der dargestellte dritte und vierte Transistor T3, T4. Jedoch können alternativ anstelle solcher kreuzgekoppelter Transistoren beispielsweise aktive Stromquellen, Dioden oder ohmsche Widerstände eingesetzt werden.

Anhand Fig. 3 ist mittels einer Tabelle der Signalzustand an verschiedenen Punkten einer solchen Schaltungsanordnung skizziert. Die erste Spalte zeigt den Zustand des Eingangssignals in. Die zweite Spalte zeigt den Signalzustand am ersten Knoten a. Die dritte Spalte zeigt den Signalzustand am zweiten Knoten b und die vierte Spalte zeigt den Signalzustand am Ausgangsknoten c, d. h. das Ausgangssignal out. In der ersten Zeile ist der Fall eines niedrigpegeligen Eingangssignals mit dem Zustand 0 dargestellt. In korrekter Art und Weise sind die Zustände des ersten und des zweiten Knotens a, b 1 bzw. 0 und der Zustand des Ausgangssignals ebenfalls 0. Die dritte Zeile zeigt den alternativ korrekten Betriebszustand mit einem hochpegeligen Eingangssignal und Zuständen am ersten und zweiten Knoten a, b mit Werten 0 bzw. 1 sowie einem hochpegeligen Ausgangssignal out.

Die zweite Zeile zeigt den ersten möglichen falschen Zustand auf Grund beispielsweise eines Spannungsrauschens und/oder Auseinanderdriftens der beiden Grundspannungen VSS1/VSS2. Dargestellt ist ein niedrigpegeliges Eingangssignal in mit korrektem hochpegeligen Zustand des ersten Knoten a jedoch falschem hochpegeligen Zustand 1 des zweiten Knoten b. Trotzdem wird bei dieser Schaltungsanordnung eine korrektes Ausgangssignal mit niedrigem Pegel ausgegeben, da der vorherige niedrigpegelige Wert gehalten wird.

Die korrekte Funktion wird somit insbesondere dann ermöglicht, wenn die Schaltungsanordnung sich auf einen korrekten Zustand eingepegelt hat und in diesem korrekten Zustand eine insbesondere kurzzeitige Störung eintritt. Die vierte Zeile zeigt letztendlich den zweiten möglichen Fehlerzustand im Falle eines hochpegeligen Eingangssignals, wobei sowohl der erste als auch der zweite Knoten a, b beide hochpegelig sind. Trotzdem wird das Ausgangssignal out hochpegelig auf dem letzen hochpegeligen Wert gehalten.

## Patentansprüche

1. Schaltungsanordnung zur Glitch-freien oder Glitch-reduzierten Signalübertragung zwischen Spannungsbereichen mit
- einer Open-drain-Schaltung (1) in einem ersten Spannungsbereich (V1) und einer Last (2) in einem zweiten Spannungsbereich (V2),
- wobei die Open-drain-Schaltung (1) ausgebildet ist, abhängig von einem Zustand eines Eingangssignals (in) an einem ersten Knoten (a) und einem zweiten Knoten (b), welche der Last (2) angelegt sind, ein Signal anzulegen und
- wobei abhängig von dem Zustand des ersten Knoten (a) ein Ausgangssignal (out) ausgegeben wird,
**dadurch gekennzeichnet, dass**
- eine Auswertelogik (3) der Last (2) nachgeschaltet ist, wobei die Auswertelogik (3) zum Bereitstellen des Ausgangssignals (out) zum Auswerten des Zustands des ersten Knotens (a) und des Zustands des zweiten Knotens (b) ausgebildet ist.

2. Schaltungsanordnung nach Anspruch 1, bei welcher die Open-drain-Schaltung (1) das Eingangssignal an einem ersten Transistor (T1) und über einen ersten Inverter (inv1) an einem zweiten Transistor (T2) anlegt, wobei der erste Transistor (T1) schaltbar ist, den ersten Knoten (a) auf eine erste Grundspannung (VSS1) des ersten Spannungsbereichs (V1) zu schalten, und wobei der zweite Transistor (T2) ausgelegt ist, den zweiten Knoten (b) auf die erste Grundspannung (VSS1) zu schalten.

3. Schaltungsanordnung nach Anspruch 1 oder 2, bei welcher die Last (2) einen dritten Transistor (T3) und einen vierten Transistor (T4) aufweist, wobei der dritte Transistor (T3) geschaltet ist, abhängig vom Zustand des zweiten Knotens (b) den ersten Knoten (a) auf eine Versorgungsspannung (VDD2) des zweiten Spannungsbereichs (V2) zu schalten, und wobei der vierte Transistor (T4) geschaltet ist, den zweiten Knoten (b) abhängig vom Zustand des ersten Knotens (a) auf die Versorgungsspannung (VDD2) zu schalten.

4. Schaltungsanordnung nach einem vorstehenden Anspruch, bei welcher die Auswertelogik (3) einen fünften Transistor (T5) aufweist, der über einen zweiten Inverter (inv2) mittels des zweiten Knotens (b) geschaltet wird, und einen sechsten Transistor (T6) aufweist, welcher über den Zustand des ersten Knotens (a) geschaltet wird, wobei ein Ausgangsknoten (c) zum Bereitstellen der Ausgangssignals (out) zwischen den fünften und den sechsten Transistor (T5, T6) geschaltet ist und wobei der fünfte Transistor (T5) über den zweiten Inverter (inv2) mittels des zweiten Knotens (b) zum Schalten des Ausgangsknotens (c) auf eine zweite Grundspannung (VSS2) des zweiten Spannungsbereichs schaltbar ausgebildet ist und wobei der sechste Transistor (T6) den Ausgangsknoten (c) auf eine Versorgungsspannung (VDD2) des zweiten Spannungsbereichs (V2) schaltbar ausgebildet ist.

5. Schaltungsanordnung nach Anspruch 4, bei welcher an dem Ausgangsknoten (c) ein Latch (L) zum statischen Halten des letzten Ausgangszustands angelegt ist.

6. Schaltungsanordnung nach einem vorstehenden Anspruch mit einem zwischen den ersten Transistor (T1) und den ersten Knoten (a) geschalteten ersten Widerstand (R1), einem zwischen den zweiten Transistor (T2) und den zweiten Knoten (b) geschalteten zweiten Widerstand (R2), einer zwischen eine zweite Grundspannung (VSS2) des zweiten Spannungsbereichs (V2) und den ersten Knoten (a) geschalteten ersten Diode (D1) und einer zwischen die zweite Grundspannung (VSS2) und den zweiten Knoten (b) geschalteten zweiten Diode (D2) als ESD-Schutzschaltung.

7. Impulsweiten-modulierter Verstärker mit einer Schaltungsanordnung nach einem der vorstehenden Ansprüche.
